# EUROPEAN PATENT SPECIFICATION

(11) **EP 1 683 883 B1**
(45) Date of publication and mention of the grant of the patent: **18.05.2011**
(21) Application number: 06000270.6
(22) Date of filing: 07.01.2006
(51) Int. Cl.: C22C 27/04, C23C 14/00

(54) **Molybdenum alloy**
Molybdän-Legierung
Alliage de molybdène

(30) Priority: 21.01.2005 DE 102005003445
(43) Date of publication of application: 26.07.2006
(73) Proprietor: H. C. Starck Hermsdorf GmbH, 07629 Hermsdorf (DE)
(72) Inventor: Reis, Hans-Henning, Dr., 07639 Bad Klosterlausnitz (DE); Furche, Thomas, 07768 Altendorf (DE); Andersson, Klaus, Dr., 07768 Kahla (DE)
(74) Representative: Clauswitz, Kai-Uwe Wolfram

(56) References cited:
- WO-A-2004/095501
- JP-A- 48 036 018
- US-A- 2 850 385
- M.K. MILLER, E.A. KENIK, M.S. MOUSA, K.F. RUSSELL, A.J. BRYHAN: "Improvement in the ductility of molybdenum alloys due to grain boundary segregation" SCRIPTA MATERIALIA, vol. 46, 2002, pages 299-303, XP002375456
- NIEH T G ET AL: "IMPROVED UNDERSTANDING OF THE MECHANICAL BEHAVIOR OF MOLYBDENUM ALLOYS AT ELEVATED TEMPERATURES" MOLYBDENUM AND MOLYBDENUM ALLOYS, XX, XX, 1989, pages 89-97, XP009050724
- R. KIEFFER, E. PIPITZ: "Sintered and Arc-melted molybdenum alloys" 1958, ASM PUBLICATIONS , XP009064658 * the whole document *

## Description

The invention relates to a molybdenum alloy and its use for metal substrate material for high-temperature applications. In particular, the invention relates to a metal substrate material consisting of molybdenum alloy for the anode disks of rotating anode x-ray tubes for high power requirements, a process for the production of such a material and a process for the production of an anode disk using such a material.
The invention furthermore relates to sputtering target consisting of molybdenum alloy and process for producing the sputtering targets.

Anode disks in systems of this type are known to be subject to extreme thermal and mechanical stresses. These parts are therefore made from alloys of the high-melting-point metals tungsten, molybdenum and rhenium. To increase the heat capacity, it is conventional to solder a graphite backing on to the reverse side as heat capacity. The x-ray active layer is produced from a tungsten-rhenium alloy with an extremely high loading capacity.

The manufacture generally takes place by a powder metallurgy route in the following steps: powder preparation, layer compaction, sintering, forging and finishing. More recent developments focus on the application of the x-ray active layer by coating methods.

Of great importance for the functioning of the component is the metal substrate, on one side of which the x-ray active layer and on the other side of which the graphite is applied.

This substrate is normally produced from TZM, which is molybdenum dispersion-alloyed with titanium, zirconium and carbon compounds. These additives block the dislocation motion at the grain boundaries, which on the one hand inhibits the extremely embrittling behaviour known in molybdenum as secondary grain growth as a result of advancing recrystallisation up to temperatures of 1600°C, and at the same time also brings about a significant improvement in the strength properties up to this temperature range.

Similar effects can be achieved by using a substitutional solid solution of molybdenum and tungsten.

Anode disks of molybdenum with additives of niobium produced by powder metallurgy are also known for mammography x-ray tubes.

Dispersion alloys have limited application possibilities. If sufficient thermal energy is introduced into the system, thermodynamic conditions arise to overcome the blockages of the dislocation motion caused by the foreign particles disperse stored at the grain boundaries. Advancing recrystallisation associated with secondary grain growth in particular cases is the unavoidable consequence. Associated with this is a considerable loss of strength, particularly a reduction in the yield point of the material, which clearly exceeds mechanical loads caused by heat. Such processes can be observed in TZM in the temperature range above 1600°C.

In addition to high temperature resistance, vacuum performance and thermal conductivity, the creep properties of the molybdenum alloy and of the substrate material are of great importance for the present application.

As mentioned above, large rotating anode disks can be backed with graphite. Soldering temperatures of up to 1900°C or more are used for this process, which results in the thermodynamic effects explained above.

In the tube insert, the disk is subject to extreme tangential, and as a result, tensile stresses at rotational speeds of up to 15,000 rotations per minute at base temperatures above 1600°C. Under these conditions, creep processes set in which, while they do not lead to the destruction of the disk in long-term use, do however reach values of more than 0.3%. Although it is only microcreep, this is a value that significantly exceeds the elongation properties of the soldered joint. Separation of the graphite backing occurs, and thus the rotating anode fails and the x-ray tubes are destroyed with high economic loss.

Another aspect is the vacuum performance. The alloying elements introduced in dispersion in TZM are ultimately impurities, which can impair the tube vacuum. The long-term diffusion of carbon in particular to the disk surface can lead to tube failure.

The substitutional solid solution alloy of molybdenum and tungsten brings clear advantages over pure molybdenum. The desired effects can only be observed with relatively high tungsten contents, however. This means on the one hand a marked increase in mass and on the other hand considerable losses of thermal conductivity. Moreover, TZM appears superior to this combination in its action.

The application of the substitutional solid solution of molybdenum and niobium has only been able to find limited acceptance up to now in mammography applications. This can be attributed to the reactivity of niobium towards hydrogen. A hydrogen atmosphere is almost unavoidable when processing molybdenum by powder metallurgy, however. Molybdenum-niobium alloys produced by powder metallurgy overcoming these problems have proved inferior to TZM in terms of their high temperature resistance properties.

In principle, molybdenum alloys with niobium produced in the molten state are known (CH 328 506), but this technical solution is based on a completely different object from the present invention, i.e. to achieve hot-forming properties. This publication also fails to mention zirconium, and niobium is named on an equal standing to vanadium and titanium, which play no part in the present invention.

It is also known to add about 0.02 wt.% of amorphous boron and a multiple of this amount of silicon during the production of molybdenum semi-finished products in the molten state to achieve fine grain structure and ductility (DD 288 509).

US 3689795 shows rotating X-ray targets of a molybdenum alloy comprising up to 10 weight % of tungsten, tantalum, niobium, rhenium or osmium and up to 1.5 weight % of titanium and up to 0.5 weight % of zirconium.

US 2883284 shows an alloy comprising 0.5 weight % of zirconium, 1 weight % of niobium and an alloy comprising 2.5 weight % titanium, 2 weight % of niobium and 0.4 weight % of zirconium, the balance in both alloys being molybdenum.

US 2850385 shows a molybdenum alloy having a zirconium content of 2 to 10 weight % and 5 % of niobium.

GB 798139 shows several molybdenum alloy, one of them having a zirconium content of 0.06 weight % and a niobium content of 0.5 weight %. The object of the present invention is to provide a molybdenum alloy for high temperature applications, which can advantageously be used as initial material for metal substrate material for the production of anode disks of rotating anode x-ray tubes for high powder requirements and for production of sputtering targets.

This object is achieved by molybdenum alloy comprises 95 to 97 weight % of molybdenum, 2 to 4 weight % of niobium and 0.05 to 0.2 weight % of zirconium, and most preferably of 95 to 97 weight % of molybdenum, 3 to 4 weight % of niobium and 0.05 to 0.2 weight % of zirconium, the residual carbon and residual oxygen contents are each guaranteed to be less than 30 ppm by mass.

The molybdenum alloy according to present invention characterised in that the niobium is predominantly bound with the molybdenum in the substitutional solid solutions. Preferably, more than 95 weight % of the niobium is bound with the molybdenum in the substitutional solid solutions. According to the present invention, the molybdenum alloy is characterised in that zirconium exhibits dispersion blocking at the grain boundaries.

The molybdenum alloys, according to the present invention, are very pure, as such, have a purity of at least 99.95 %, in some cases at least 99.99 %, in other cases at least 99.999 %.According to the present invention, the molybdenum alloys are produced by melL metallurgy (pyrometallurgy).

The hardening of the alloy produced in the molten state is substantially attributable to states of microstress, which are produced latently by the difference in the coefficients of thermal expansion between molybdenum and niobium in the optimised composition ranges. Material of the same composition produced by powder metallurgy, on the other hand, is not equivalent.
The molybdenum alloys, according to the present invention are used for the production of high temperature materials for vacuum applications, preferably for the production of metal substrate material for the anode disks of rotating anode x-ray tubes. The advantage of metal substrate material according to the present invention is improving the service life of both x-ray rotating anode disks and thus the x-ray devices fitted with them under increasing thermal and mechanical stresses (higher rotational speed) by improving the material of the metal substrate of these x-ray rotating anode disks. The metal substrate according to the present invention shows improved creep properties.
The creep process of metal substrate measured by DIN EN 1606 reaches value of less than 0.3, preferably less than 0.2, more preferably less than 1.5. In particular cases, metal substrate material shows no creep process.

The present invention therefore provides a metal substrate material consisting of molybdenum alloy.

The present invention provides also a process for the production of metal substrate material in that the melting of the initial compounds, e.g. molybdenum and niobium metal, takes place in a high vacuum.

The cast structure of the high-melting-point metals of subgroups V A and VI A, (vanadium, niobium, tantalum, chromium, molybdenum and tungsten) of the periodic table is known to be very coarse-grained, which can result in insufficient grain-boundary strength in the cast state. This problem is overcome by microalloying with amorphous boron, which is added to the input stock in quantities of no more than 0.02 wt.%, preferably of 0.001 to 0.02 weight %, contributes towards nucleation and deoxidation during the melting process, mostly evaporates during vacuum melting and can normally only be detected qualitatively in the melt product.

It is, of course, impossible to apply the x-ray active layer (focal path) of tungsten-rhenium alloy or other suitable material onto this new substrate material by powder metallurgy. This therefore takes place by a suitable coating method, preferably by vacuum plasma spraying.

Its desired properties relating to high-temperature strength under the particular conditions of use as a substrate material for rotating anode disks in high-power x-ray tubes can be displayed by the new alloy particularly if the grain boundary strength is not decreased by undesirable interstitial impurities on the grain boundary surfaces. The best results are achieved if the production conditions are controlled in such a way that the residual carbon and residual oxygen contents are each guaranteed to be less than 30, and preferably less than 10 ppm by mass.

The molybdenum alloy according to the present invention has the following advantages:
- the alloy has high-temperature properties in terms of secondary recrystallisation stability, tensile strength, yield point and elongation equivalent to TZM in the temperature range up to 1700°C,
- in the temperature range above 1800°C, the material is superior to TZM in terms of these properties,
- high-temperature annealings above 1800°C have no substantial effect on microcreep behaviour at high temperatures. The values are significantly below those of TZM in the permissible range for the desired application,
- as a result of the lack of impurities, particularly oxygen and carbon, the high-vacuum performance of the material is particularly good,
- although the thermal conductivity of the material is somewhat poorer than that of TZM as a result of metal physics, the advantages far outweigh this disadvantage,
- the melt-metallurgical technology and the possibility of reprocessing offer clear cost advantages in production and recycling.

The molybdenum-niobium-zirconium material according to the invention is not only suitable as a substrate material for rotating anode disks in high-power x-ray tubes but can also be used for sputtering targets.

In many cases, sputtering targets, particularly those containing molybdenum, have a wrought microstructure with non-uniform grain texture, which may change from one sputtering target to the next. These "non-uniformities" lead to non-uniform films being deposited onto substrates and devices, particularly flat panel displays that do not operate optimally.
In other cases, molybdenum-based sputtering targets are manufactured using a conventional thermomechanical working step. Unfortunately, this methodology generally induces heterogeneity of grain size and texture. The heterogeneity in the sputtering targets typically leads to sputtered films that do not possess the uniformity desired in most semiconductor and photoelectric applications.
The metal substrate material according to the present invention is advantageously used for sputtering targets.

The present invention therefore also provides molybdenum alloy sputtering targets, having fine, uniform grain size as well as uniform texture substantially free of both texture banding and through thickness gradient from a center to an edge of the target with high purity.

As used herein, the term "banding" refers to non-uniformities in the grain or texture, the grain size, or grain orientation that occur in a strip or pattern along the surface of the sputtering target. As used herein, the term "through thickness gradient" refers to changes in grain or texture, grain size, or grain orientation moving from the edge of the target to the center of the target.

The present invention provides a tubular-shaped sputtering target and its method of manufacture. The present method involves the use of molybdenum alloy powder as a starting material, and its consolidation to a substantially fully dense article in the form of a tube. The molybdenum alloy powder is produced by grinding of the molybdenum alloy according to the invention. The tubular form produced has a fine, uniform grain size, and a texture which is substantially uniform throughout, and does not change from tube to tube. The present invention additionally relates to a method for making a tubular-shaped sputtering target by:
A)placing molybdenum alloy powder in a mold and pressing the powder at a pressure of from 2.200 to 2.760 bar and sintering the pressed piece at a temperature of from 1785 to 2175°C to form a billet;
B)removing the center of the billet to form a tubular billet having an inner diameter ID_{I} and an outer diameter OD_{I};
C)working the tubular billet to form a worked billet having an inner diameter ID and an outer diameter OD_{f} such that the ratio of OD_{I} to OD_{f} is at least 3:1; and
D)heat treating the tubular billet at a temperature of from 815 to 1375°C.

According to the present invention, a tubular-shaped sputtering target is formed by the pressing and sintering of molybdenum alloy powder to form a billet, removing the center of the billet, working the billet, and heat treating the billet to form a tubular-shaped sputtering target.

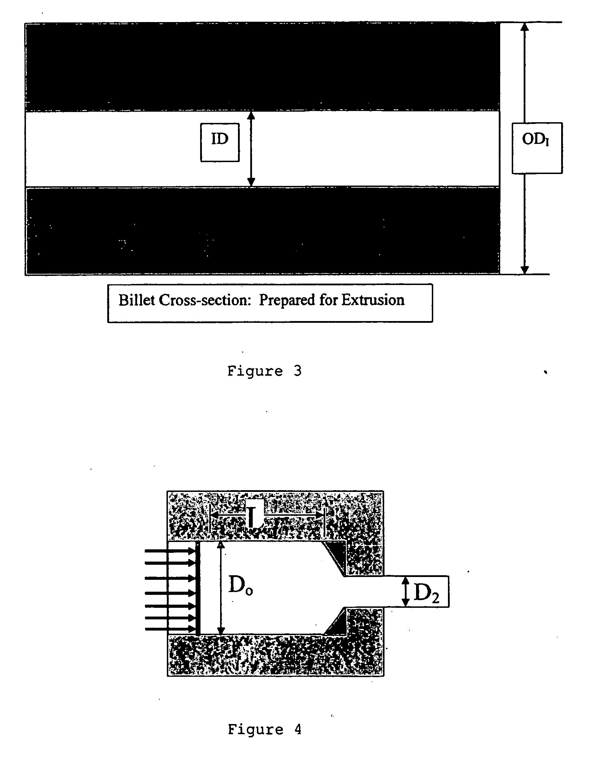

Typically, the molybdenum alloy powder is placed in a mold and the powder is pressed at a pressure of at least 2200 bar. Also, the powder can be pressed at a pressure of up to 2760 bar. The molybdenum alloy powder in the mold can be pressed at any pressure recited above or at pressures ranging between any of the pressures recited above.
Further, when the pressed billet is sintered in the mold, it is sintered at a temperature of at least 1785°C, in some cases at least 1800°C and in other cases at least 1850°C. Also, the pressed billet can be sintered at a temperature of up to 2175°C and in other cases up to 2150°C. The pressed molybdenum billet in the mold can be sintered at any temperature recited above or at temperatures ranging between any of the temperatures recited above.
The pressing of the powders is performed isostatically.
The powder is sintered in inert gas, e.g argon or vacuum.
As shown in Figure 3, the center of the consolidated billet is removed through trepanning such that the ID_{I} is smaller than the inside diameter of the finished tubular form. The OD_{I} is selected such that the ratio of reduction in cross-sectional area normal to the billet length is at least 3:1, in some cases at least 3.5:1 and in other cases at least 4:1. Also, the reduction in cross-sectional area normal to the billet length can be up to 12:1, in some cases up to 10:1 and in other cases up to 8:1. Preferably, the reduction in cross-sectional area normal to the billet length is 4.9:1 or higher.
The tubular billet is worked to form a worked billet having an inner diameter ID and an outer diameter OD_{f} such that the ratio of OD_{I} to OD_{f} is as described above.
The tubular billet is worked by extruding the billet, as shown in Figure 4. The billet is extruded with a reduction ratio (created by the change of OD_{I} to OD_{f}) in cross-sectional area as described above. The billet length may be variable. The product form ID is controlled through the use of mandrel tooling.
The tubular billet can be extruded at a temperature of at least 925°C, in some cases at least 950°C, and in other cases at least 1000°C. Also, the tubular billet can be extruded at a temperature of up to 1370°C, in some cases up to 1260°C and in other cases up to 1175°C. The tubular billet can be extruded at any temperature recited above or at a temperature ranging between any of the temperatures recited above.
After working the billet, it is heat treated at a temperature of at least 815°C, in some instances at least 925°C, in some cases at least 950°C and in other cases at least 1000°C. Also, the heat treatment can be carried out at up to 1375°C, in some cases up to 1260°C and in other cases up to 1175°C. The heat treatment can be at any temperature or range between any temperatures recited above.

In a particular embodiment of the invention, the heat treatment is carried out at temperatures from 1250 to 1375°C.
In another particular embodiment of the invention, the heat treatment is carried out at temperatures from 815 to 960°C.
A particular advantage of the present tubular-shaped sputtering target is its uniform texture. The sputtering target is completely recrystallized and strain-free.
There is no banding of texture at all. The fine, uniform grain size, and the uniformity of texture through the thickness of the tube and along the length of the tube are features which distinguish the present invention from the prior art.
These features allow for more uniform film deposition during sputtering operations.
Thus, the present invention provides a sputtering target having a uniform and fine texture and grain structure. In an embodiment of the invention, the grain size is at least 22 µm, and in some cases at least 45 µm. More importantly, however, the average grain size is not more than 125 µm, in some cases not more than 90 µm and in other cases not more than 65 µm.

The present invention provides also a disc-shaped sputtering targets and its method of manufacture.
Embodiments of the invention are also directed to a novel method of manufacturing of disc-shaped sputtering targets, which produces performance superior to that which is presently known in the art. This method of manufacture involves the use of molybdenum alloy powder as a starting material and its consolidation to a substantially fully dense article in the form of a plate. The inventive plate, which is produced through a multi-directional thermomechanical working process as described below, has a fine, uniform grain size and a texture which is substantially uniform throughout the plate.
In an embodiment of the invention, the plates have a texture that is substantially free of banding and substantially free of any through thickness gradient.
Thus, in a first step A), the molybdenum alloy powder is, placed in a mold and pressed at a pressure of at least 1000 bar, in some cases at least 2000 bar and in other cases at least 2500 bar. Also, the powder can be pressed at a pressure of up to 2750 bar. The molybdenum alloy powder in the mold can be pressed at any pressure recited above or at pressures ranging between any of the pressures recited above.
Further, after the molybdenum alloy powder is pressed in the mold, it is sintered at a temperature of at least 1785°C. Also, the powder can be sintered at a temperature of up to 2175°C, in some cases up to 2200°C. The pressed molybdenum alloy workpiece can be sintered at any temperature recited above or at temperatures ranging between any of the temperatures recited above.

In an embodiment of the present invention, a sputtering target is provided having a uniform and fine texture and grain structure. In an embodiment of the invention, the grain size is at least 22 µm and in some cases at least 65 µm. More importantly, however, the average grain size is not more than 125 µm, in some cases not more than 90 µm and in other cases not more than 65 µm as determined by electron backscatter diffraction. When the grain size is too large and/or non-uniform, thin films formed from sputtering the present sputtering target will not have the desired uniform texture and/or film thickness. The grain size in the present sputtering target can be any value or range between any values recited above.

Additionally, the present invention provides a method of sputtering, whereby any of the above-described sputtering targets are subjected to sputtering conditions and are thereby sputtered.
Any suitable sputtering method can be used in the present invention. Suitable sputtering methods include, but are not limited to, magnetron sputtering, pulse laser sputtering, ion beam sputtering, triode sputtering, and combinations thereof.

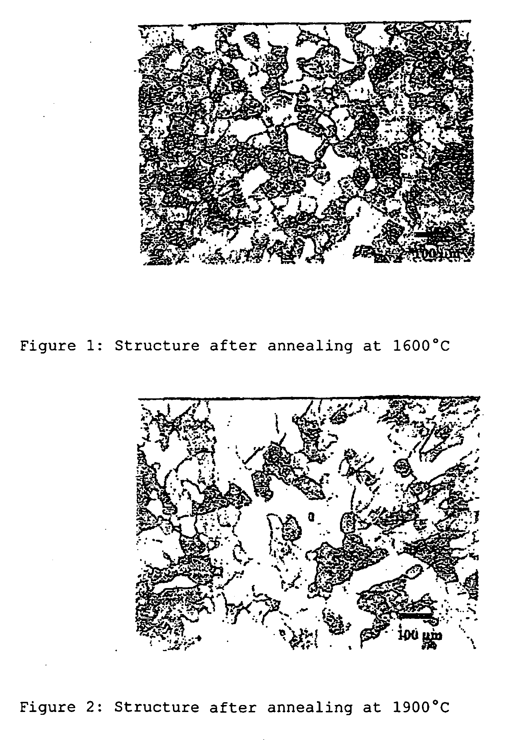

The invention is described below in more detail on the basis of an example. Figures 1 and 2 are showing enlarged structural photographs of a material according to the invention after treatment by annealing at different temperatures. The quasi-homogeneous structure of the molybdenum-niobium-zirconium solid solutions becomes clear. Even high-temperature treatments - as can be seen - do not result in any secondary grain growth. Thus, the action of the solution according to the invention is documented. The individual elements can be detected qualitatively and quantitatively by suitable methods.
The present invention provides a molybdenum-niobium-zirconium-alloy for high-temperature applications in vacuum.
In an embodiment of the invention the starting materials, molybdenum, niobium and zirconium (input stock), is melted in an electron - beam furnace to obtain an ingot. In order to avoid the oxidation during the electron-beam melting up to 300 ppm, preferably up to 200 ppm, particularly preferably up to 100 ppm boron are added to the input stock. The resulting ingot is then processed by suitable forming processes, such as extruding, rod-extrusion, forging and heat treatment (annealing). The heat treatment is carried out at from 1300 to 1500 °C, preferably at 1350 to 1450 °C, particularly preferably at 1380 to 1400 °C. After the forming and heat treatment the semi-finished product is processed into substrates for high-temperature applications by forming processes such as forging, rolling or milling.
If the substrate material is to become rotating anode disc, a x-ray active layer is to be applied to the surface thereof. This can be done by conventional methods, such as, but not limited to, vacuum plasma spraying or inductive vacuum plasma spraying. The x-ray active layer may consists of any materials suitable therefore and in general is a tungsten-rhenium layer.
The resulting parts are processed into rotating anode disks by conventional methods, e.g. drilling, milling, turning or grinding.
In a specific embodiment, the part is processed to a rotating anode disc by a process comprising the steps of
1) turning
2) milling
3) drilling and
4) grinding.

After working the disks, the heat treatment is carried out to achieve a uniform, completely recrystallised structure illustrated by light microscopy in Figure 1. The heat treatment is carried out at from 1400 to 1800°C, preferably from 1500 to 1700°C, particularly preferably from 1550 to 1650°C, very particularly preferably 1550 to 1600°C. The following heat treatment of the anode disks at from 1800 to 2000°C, preferably from 1850 to 1950°C, results in structure which is characterized by complete molybdenum-niobium solid solution formation, Figure 2.
The metal substrate material according to the present invention shows the relatively uniform and completely recrystallised structure. The structure is uniform if a distribution of grain sizes that vary by less than 30 percent across the surface of any plane of said substrate material, said planes being selected from planes that are orthogonal to the thickness of said substrate material, and planes that are diagonal to the thickness of said substrate material, and a distribution of grain sizes that vary by less than 30 percent across any thickness of said substrate material.
The invention is illustrated in further detail below by reference to examples, wherein the examples are intended to simplify understanding of the principle according to the invention and should not be understood as a limitation thereof.

### Example 1

- 96.5 kg molybdenum, 3.45 kg niobium and 0.05 kg zirconium are prepared as the input stock,
- 100 ppm by mass of boron are added to this input stock,
- the feedstock is melted in an electron-beam furnace,
- the resulting ingot is processed by extruding and annealing at 1350°C,
- the semi-finished product is processed into substrates for rotating anode disks by forging and annealing at 1500°C,
- a tungsten-rhenium layer is applied on to these substrates by means of a vacuum plasma spraying process,
- the resulting parts are processed into rotating anode disks by sequential steps:
   1) turning
   2) milling
   3) drilling and
   4) grinding,
- following a heat treatment at 1600°C for 2 hours, the substrates of the rotating anode disks are characterised by the relatively uniform, completely recrystallised structure illustrated by light microscopy in the attached Figure 1, with the average grain size stated,
- following heat treatment at 1900°C for 1 hour,
- the structure of the substrate is characterised by complete molybdenum-niobium solid solution formation,
- zirconium and boron can be detected relatively uniformly in the substrate structure,
- the residual carbon content is less than 10 ppm by mass,
- the residual oxygen content is less than 10ppm by mass.

### Example 2

- 97.5 kg molybdenum, 2.45 kg niobium and 0.05 kg zirconium are prepared as the input stock,
- the feedstock is melted in an electron-beam furnace,
- the resulting ingot is processed by extruding and annealing at 1450°C,
- the semi-finished product is processed into substrates for rotating anode disks by forging and annealing at 1450°C,
- a tungsten-rhenium layer is applied on to these substrates by means of a vacuum plasma spraying process,
- the resulting parts are processed into rotating anode disks by sequential steps:
   1) turning
   2) milling
   3) drilling and
   4) grinding,
- following a heat treatment at 1550°C for 2 hours, the substrates of the rotating anode disks are characterised by the relatively uniform and completely recrystallised structure,
- following heat treatment at 1850°C for 1 hour,
- the structure of the substrate is characterised by complete molybdenum-niobium solid solution formation,
- zirconium can be detected relatively uniformly in the substrate structure,
- the residual carbon content is less than 10 ppm by mass,
- the residual oxygen content is less than 30 ppm by mass.

### Example 3

- 96.99 kg molybdenum, 3.0 kg niobium and 0.01 kg zirconium are prepared as the input stock,
- 50 ppm by mass of boron are added to this input stock,
- the feedstock is melted in an electron-bombardment furnace,
- the resulting ingot is processed by extruding and annealing at 1350°C,
- the semi-finished product is processed into substrates for rotating anode disks by forging and annealing at 1500°C,
- a tungsten-rhenium layer is applied on to these substrates by means of a vacuum plasma spraying process,
- the resulting parts are processed into rotating anode disks by sequential steps:
   1) turning
   2) milling
   3) drilling and
   4) grinding,
- following a heat treatment at 1650°C for 2 hours, the substrates of the rotating anode disks are characterised by the relatively uniform, completely recrystallised structure,
- following heat treatment at 1950°C for 1 hour,
- the structure of the substrate is characterised by complete molybdenum-niobium solid solution formation,
- zirconium and boron can be detected relatively uniformly in the substrate structure,
- the residual carbon content is less than 10 ppm by mass,
- the residual oxygen content is less than 15 ppm by mass.

## Claims

1. Molybdenum alloy comprising 95 to 97 weight % of molybdenum, 2 to 4 weight % of niobium and 0.05 to 0.2 weight % of zirconium, residual carbon and residual oxygen contents of the finished material are kept to less than 30 ppm, the sum of the elements being 100 weight %.

2. Molybdenum alloy according to claim 1, **characterised in that** more than 95 weight % of the niobium is bound with the molybdenum in a substitutional solid solutions.

3. Molybdenum alloy according to any of claims 1 to 2, having a purity of at least 99.95 %.

4. Molybdenum alloy according to any of claims 1 to 3, **characterised in that** the molybdenum alloy produced by high vacuum melt metallurgy.

5. Use of molybdenum alloy according to any preceding claims for producing high temperature materials for vacuum applications.

6. Metal substrate material consisting of a molybdenum, alloy according to any of claims 1 to 4.

7. Anode disks for rotating anode x-ray tubes, sputtering target, tubular sputtering target, disk-shaped sputtering target, round sputtering target, square sputtering target, or rectangular sputtering target comprising a substrate of claim 6.

8. Sputtering target according to claim 7, wherein the fine,uniform average grain size is not more than 125 µm .

9. A method of sputtering, comprising subjecting a sputtering target, tubular sputtering target or disk-shaped sputtering target of claim 7 to sputtering conditions and thereby sputtering the target.

10. A method of claim 9, wherein the sputtering is done using a sputtering method selected from the group consisting of magnetron sputtering, pulse laser sputtering, ion beam sputtering triode sputtering, and combinations thereof.

11. Process for the production of material according to claim 1, **characterised in that** the melting of the components takes place in a high vacuum, wherein up to 200 ppm of amorphous boron are added to the input stock.

12. Process according to claim 11, **characterised in that** the residual carbon and residual oxygen contents of the finished material are kept to less than 10 ppm by mass in each case.

13. Process for the production of an anode disk for rotating anode x-ray tubes according to claim 7, **characterised in that** the x-ray active layer is applied by vacuum plasma spraying or inductive vacuum plasma spraying.

14. Process according to claim 13, **characterised in that** the x-ray active layer is a tungsten-rhenium alloy.

15. A method of making a tubular-shaped sputtering target according to claim 7 comprising:
A)placing molybdenum alloy powder having a composition of any of claims 1 to 4 in a mold and pressing the powder at a pressure of from 2.200 to 2.760 bar and sintering the pressed pierce at a temperature of from 1785 to 2175°C to form a billet;
B) removing the center of the billet to form a tubular billet having an inner diameter ID_{I} and an outer diameter OD_{I};
C)working the tubular billet to form a worked billet having an inner diameter ID and an outer diameter ODᵣ such that the ratio of OD_{I} to ODᵣ is at least 3:1; and
D) heat treating the tubular billet at a temperature of from 815 to 1375°C.

16. A method according to claim 15, wherein the pressing in A) is performed isostatically.

17. A method according to claim 15, wherein the powder in A) is sintered in inert gas or vacuum.

18. A method according to claim 15, wherein ID is greater than IDᵣ.

19. A method according to claim 15, wherein the working in C) comprises extruding the tubular billet at a temperature of from 925 to 1260°C.

20. A method according to claim 15, wherein after heat treating in D), the sputtering target is completely recrystallized and strain-free.

21. A method according to claim 15, wherein the heat treatment in D) is carried out at from 1250 to 1375°C, preferably from 815°C to 960°C.

## Patentansprüche

1. Molybdänlegierung, die 95 bis 97 Gew.-% Molybdän, 2 bis 4 Gew.-% Niob und 0,05 bis 0,2 Gew.-% Zirkonium umfasst, wobei der Restkohlenstoffgehalt und der Restsauerstoffgehalt des fertigen Materials auf weniger als 30 ppm gehalten werden, wobei die Summe der Elemente 100 Gew.-% beträgt.

2. Molybdänlegierung nach Anspruch 1, **dadurch gekennzeichnet, dass** mehr als 95 Gew.-% des Niob in einem Substitutionsmischkristall an das Molybdän gebunden sind.

3. Molybdänlegierung nach einem der Ansprüche 1 bis 2, die eine Reinheit von mindestens 99,95 % aufweist.

4. Molybdänlegierung nach einem der Ansprüche 1 bis 3, **dadurch gekennzeichnet, dass** die Molybdänlegierung durch Hochvakuum-Schmelzmetallurgie hergestellt wird.

5. Verwendung einer Molybdärlegierung nach einem der vorangehenden Ansprüche zum Herstellen von Hochtemperaturmaterialien für Vakuumanwendungen.

6. Metal-substratmaterial, das aus einer Molybdänlegierung nach einem der Ansprüche 1 bis 4 besteht.

7. Anodenscheiben für Drehanoden-Röntgenröhren, Sputter-Targets, röhrenförmige Sputter-Targets, scheibenförmige Sputter-Targets, runde Sputter-Targets, quadratische Sputter-Targets oder rechteckige Sputter-Targets, umfassend ein Substrat nach Anspruch 6.

8. Sputter-Target nach Anspruch 7, wobei die feine, gleichmäß-ge durchschnittliche Korngröße nicht mehr als 125 µm beträgt.

9. Sputterverfahren, das umfasst, ein Sputter-Target, röhrenförmiges Sputter-Target oder scheibenförmiges Sputter-Target nach Anspruch 7 Sputterbedingungen auszusetzen und **dadurch** das Target zu bedampfen.

10. Verfahren nach Anspruch 9, wobei das Sputtern unter Verwendung eines Sputterverfahrens erfolgt, das ausgewählt ist aus der Gruppe bestehend aus Magnetron-Sputtern, Puls-Laser-Sputtern, Ionenstrahl-Sputtern, Trioden-Sputtern und Kombinationen davon.

11. Prozess für die Herstellung von Material nach Anspruch 1, **dadurch gekennzeichnet, dass** das Schmelzen der Komponenten in einem Hochvakuum stattfindet, wobei dem eingesetzten Material bis zu 200 ppm amorphes Bor beigegeben werden.

12. Prozess nach Anspruch 11, **dadurch gekennzeichnet, dass** der Restkohlenstoffgehalt und der Restsauerstoffgehalt des fertigen Materials in jedem Fall auf weniger als 10 Masse-ppm gehalten werden.

13. Prozess für die Herstellung einer Anodenscheibe für Drehanoden-Röntgenröhren nach Anspruch 7, **dadurch gekennzeichnet, dass** die röntgenaktive Schicht durch Vakuumplasmaspritzen oder induktives Vakuumplasmaspritzen aufgebracht wird.

14. Prozess nach Anspruch 13, **dadurch gekennzeichnet, dass** die röntgenaktive Schicht eine Wolfram-Rhenium-Lcgierung ist.

15. Verfahren zum Herstellen eines röhrenförmigen Sputter-Targets nach Anspruch 7, das Folgendes umfasst:
A) Anordnen von Molybdänlegierungspulver mit einer Zusammensetzung nach einem der Ansprüche 1 bis 4 in einem Formwerkzeug und Pressen des Pulvers mit einem Druck von 2.20C bis 2.760 bar und Sintern des Presslings bei einer Temperatur von 1785 bis 2175°C, um einen Barren zu bilden;
B) Entfernen der Mitte des Barrens, um einer röhrenförmigen Barren mit einem Innendurchmesser ID_{I} und einem Außendurchmesser OD_{I} zu bilden;
C) Bearbeiten des röhrenförmigen Barrens, um einen bearbeiteten Barren mit einem. Innendurchmesser ID und einem Außendurchmesser OD- dergestalt zu bilden, dass das Verhältnis von OD_{T} zu OD_{F} mindestens 3:1 beträgt; und
D) Wärmebehandeln des röhrenförmigen Barrens bei einer Temperatur von 815 bis 1375°C.

16. Verfahren nach Anspruch 15, wobei das Pressen in A) isostatisch durchgeführt wird.

17. Verfahren nach Anspruch 15, wobei das Pulver in A) unter Inertgas oder Vakuum gesintert wird.

18. Verfahren nach Anspruch 15, wobei ID größer als ID_{I} ist,

19. Verfahren nach Anspruch 15, wobei das Bearbeiten in C) ein Extrudieren des röhrenförmigen Barrens bei einer Temperatur von 925 bis 1260°C umfasst.

20. Verfahren nach Anspruch 15, wobei nach dem Wärmebehandeln in D) das Spuller-Target vollständig rekristallisiert und spannungsirei ist.

21. Verfahren nach Anspruch 15, wobei die Wärmebehandlung in D) von 1250 bis 1375°C, bevorzugt von 815°C bis 960°C, ausgeführt wird.

## Revendications

1. Alliage de molybdène comprenant 95 à 97 % en poids de molybdène, 2 à 4% en poids en niobium et 0,05 à 0,2 % en poids de zirconium, les teneurs en carbone résiduel et en oxygène résiduel du matériau fini étant maintenues à moins de 30 ppm, et la somme des éléments étant égale à 100 % en poids.

2. Alliage de molybdène selon la revendication 1, **caractérisé en ce que** plus de 95 % en poids du niobium sont liés au molybdène dans des solutions solides de substitution.

3. Alliage de molybdène selon l'une quelconque de revendications 1 à 2, présentant une pureté d'au moins 99,95 %.

4. Alliage de molybdène selon l'une quelconque des revendications 1 à 3, **caractérisé en ce que** l'alliage de molybdène est produit par métallurgie de fusion sous vide poussé.

5. Utilisation d'un alliage de molybdène selon l'une quelconque des revendications précédentes, pour la production de matériaux à hautes températures destinés à des applications sous vide.

6. Matériau de substrat métallique, constitué d'un alliage de molybdène selon l'une quelconque des revendications 1 à 4.

7. Disques d'anode pour des tubes à rayons X à anode tournante, cible de pulvérisation cathodique, cible de pulvérisation cathodique tubulaire, cible de pulvérisation cathodique en forme de disque, cible de pulvérisation cathodique ronde, cible de pulvérisation cathodique carrée, ou cible de pulvérisation cathodique rectangulaire, comprenant un substrat selon la revendication 6.

8. Cible de pulvérisation cathodique selon la revendication 7, dans laquelle la taille moyenne uniforme de grain fin n'est pas supérieure à 125 µm.

9. Procédé de pulvérisation cathodique, dans lequel on soumet une cible de pulvérisation cathodique, une cible de pulvérisation cathodique tubulaire ou une cible de pulvérisation cathodique en forme de disque selon la revendication 7 à des conditions de pulvérisation cathodique et on effectue ainsi la pulvérisation cathodique de la cible.

10. Procédé selon la revendication 9, dans lequel on effectue la pulvérisation cathodique en utilisant un procédé de pulvérisation cathodique sélectionné dans le groupe composé de la pulvérisation cathodique magnétron, la pulvérisation cathodique par laser pulsé, la pulvérisation cathodique par faisceau d'ions, la pulvérisation cathodique triode, et des combinaisons de celles-ci.

11. Procédé pour la production d'un matériau selon la revendication 1, **caractérisé en ce que** l'on effectue la fusion des composants sous un vide poussé, dans lequel on ajoute jusqu'à 200 ppm de bore amorphe aux matières de départ.

12. Procédé selon la revendication 11, **caractérisé en ce que** l'on maintient les teneurs en carbone résiduel et en oxygène résiduel dans le matériau fini à moins de 10 ppm en masse dans chaque cas.

13. Procédé pour la production d'un disque d'anode pour des tubes à rayons X à anode tournante selon la revendication 7, **caractérisé en ce que** l'on applique la couche active en rayons X par projection plasma sous vide ou par projection plasma à induction sous vide.

14. Procédé selon la revendication 13, **caractérisé en ce que** la couche active en rayons X est un alliage tungstène-rhénium.

15. Procédé de production d'une cible de pulvérisation cathodique de forme tubulaire selon la revendication 7, dans lequel:
A) on place une poudre d'alliage de molybdène, ayant une composition selon l'une quelconque des revendications 1 à 4, dans un moule et on compacte la poudre à une pression de 2200 à 2760 bars, et on fritte la pièce compactée à une température de 1785°C à 2175°C pour former une billette;
B) on enlève le centre de la billette de façon à former une billette tubulaire présentant un diamètre intérieur ID_{I} et un diamètre extérieur ODᵣ;
C) on façonne la billette tubulaire de façon à former une billette ouvrée présentant un diamètre intérieur ID et un diamètre extérieur OD_{f}, tels que le rapport de OD_{I} à OC_{f} soit au moins 3:1; et
D) on traite thermiquement la billette tubulaire à une température de 815°C à 1375°C.

16. Procédé selon la revendication 15, dans lequel on effectue le compactage selon A) de manière isostatique.

17. Procédé selon la revendication 15, dans lequel on fritte la poudre selon A) sous gaz inerte ou sous vide.

18. Procédé selon la revendication 15, dans lequel ID est plus grand que ID_{I}.

19. Procédé selon la revendication 15, dans lequel le façonnage selon C) comprend l'extrusion de la billette tubulaire à une température de 925°C à 1260°C.

20. Procédé selon la revendication 15, dans lequel, après le traitement thermique selon D), la cible de pulvérisation cathodique est complètement recristallisée et libre de contrainte.

21. Procédé selon la revendication 15, dans lequel on effectue le traitement thermique selon D). à une température de 1250°C à 1375°C, de préférence de 815°C à 960°C.
